Europäisches Patentamt

European Patent Office

Office européen des brevets

(10)

(11) Publication number: **0 193 674**
**B1**

(12) **EUROPEAN PATENT SPECIFICATION**

(45) Date of publication of patent specification: **14.03.90**

(21) Application number: **85306678.5**

(22) Date of filing: **19.09.85**

(51) Int. Cl.[5]: **C 23 C 10/28,** C 23 C 12/02,
C 23 C 8/10, C 23 C 26/00,
H 01 L 21/263

(54) **Method of amorphizing a solid material by injection of exotic atoms with electron beams.**

(30) Priority: **06.03.85 JP 43992/85**

(43) Date of publication of application:
**10.09.86 Bulletin 86/37**

(45) Publication of the grant of the patent:
**14.03.90 Bulletin 90/11**

(84) Designated Contracting States:
**DE FR GB**

(56) References cited:
EP-A-0 033 696      GB-A-1 194 049
EP-A-0 046 914      GB-A-2 073 254
EP-A-0 098 453      GB-A-2 125 442
EP-A-0 192 874      US-A-4 122 240
EP-A-1 811 073

CHEMICAL ABSTRACTS, vol. 98, no. 8, February
1983, page 259, no. 58393v, Columbus, Ohio,
US; P.L. BONORA et al.: "Electrochemical
corrosion behavior of ion-implanted and laser-
irradiated metals", & CORROS MET.
PROCESSED DIRECTED ENERGY BEAMS,
PROC. SYMP. 1981 (PUB. 1982), 101-17

(73) Proprietor: **OSAKA UNIVERSITY**
**1-1 Yamadaoka**
**Suita City Osaka-Fu (JP)**

(72) Inventor: **Fujita, Hiroshi**
**12-22, Yamatedai 5-Chome**
**Ibaraki City Osaka-Fu (JP)**
Inventor: **Sumida, Naoto**
**3-30-201, Wakayamadai 2-Chome**
**Shimamoto-Cho Mishima-Gun, Osaka-Fu (JP)**

(74) Representative: **Rooney, Paul Blaise et al**
**D.Young & Co. 10 Staple Inn**
**London WC1V 7RD (GB)**

Courier Press, Leamington Spa, England.

**Description**

This invention relates to a method of amorphizing a solid material by irradiation with an electron beam.

In the field of materials engineering the properties of amorphous materials have become important and materials having a new function are being developed using these properties. Known methods for producing amorphous materials are, melt quenching, vacuum deposition or sputtering, and particle beam irradiation.

The melt quenching method inevitably has the following disadvantages:—

(1) A quenching rate greater than a certain value is required for all the material to obtain a homogeneous amorphous material, so that the form produced or treated is limited to a thin ribbon or strip having a thickness of several tens μm at most. (2) As the quenching rate obtainable is limited by the nature of the elements treated and the composition of alloys treated, some materials are not amorphizable by this method and if they are the material so obtained is an aggregate of microcrystals or a mixture of amorphous materials and microcrystals. (3) For production composites of amorphous and crystalline material, a different technique for fusing the two together is required, and this limits the combination so obtainable.

Amorphous materials produced by vacuum deposition or sputtering are more homogeneous than materials produced by melt quenching. However, vacuum deposition or sputtering have the following disadvantages:—

(1) The film thickness obtainable is at most several μm. (2) The resulting composite material is produced by controlling the temperature of a substrate on which a thin film layer is deposited. However, the thickness of amorphous material obtained over the area of the whole film layer is at most several tens μm. (3) As atoms are aggregated on the substrate after the atoms are vaporized, the difference of vapor pressure and sputtering rate of atoms forming alloys causes difficulty in controlling the composition of amorphous alloys so produced.

A method of irradiation with particle beams as known from Japanese Patent Application No. 58-125,549 is a useful method and can overcome many disadvantages existing in melt quenching and vacuum deposition or sputtering techniques. However Japanese Patent Application No. 58-125,549 is limited to intermetallic compounds having specific components. Thus this method is uncertain in application to electron materials in which the properties change remarkably with a small change of the constituents of the alloys.

According to the present invention there is provided a method of amorphizing a solid material by irradiation with an electron beam, characterised by attaching to one surface of a crystalline solid material to be rendered amorphous, a film layer containing at least one type of foreign atom to be injected into the crystalline solid material so that the material and attached layer form a layered structure, and irradiating the structure with an electron beam directed towards the film layer, at an accelerated voltage of at least 200 kV, with an electron beam intensity of at least $1 \times 10^{18}$ e/cm$^2$sec and at a temperature of not more than 100°C, thereby to displace foreign atoms from the layer and inject the displaced foreign atoms into the irradiated regions of the crystalline solid material and render the crystalline material amorphous.

The mixed layer which is produced in the irradiated regions changes into an amorphous layer of desired composition and thickness.

The film layer may be attached to the crystalline solid material by vacuum deposition, sputtering, beam annealing or electrodeposition. The electron beam irradiation method of the invention by which the abovementioned amorphous materials are produced, enables amorphous materials and crystalline materials having any composition to be combined. Moreover alloys which cannot normally be made amorphous by electron beam irradiation can be amorphized by mixing with other atoms. Thus materials having new functions can be developed using the amorphous materials produced by the method of the invention.

For a better understanding of the present invention and to show how the same may be carried into effect, reference will now be made, by way of example, to the accompanying drawings, in which:

Figure 1a is a schematic perspective view of a method of the invention for amorphizing crystalline solid materials, showing irradiation of a two layer structure in any shape consisting of parent crystalline solid material (B) and a film layer (A), by electron beams directed towards the film layer,

Figure 1b is a longitudinal sectional view of the irradiated region of Figure 1a, the film layer (A) and the solid material (B) changing into an amorphous layer (C), with the amorphous layer (C) spreading in the direction of the thickness of the crystalline solid material (B) as the latter is thin,

Figure 1c is a longitudinal sectional view similar to that of Figure 1b showing a condition in which the irradiated region changes into an amorphous layer of the film layer (A) material and the material (B). As the material (B) is thick, point defects are introduced by the irradiation into the crystalline material under the amorphous layer (C). These points defects are shown by black dots bigger than the dots representing the layer (C).

Figure 2a is a schematic perspective view of an amorphous material produced by the method of the invention, which covers the surface of a bar or a pipe, and

Figure 2b is a schematic perspective view of an amorphous material produced by the method of the invention, which covers the surface of a material having a complex cross-section (in the Figure, the cross section is rectangular).

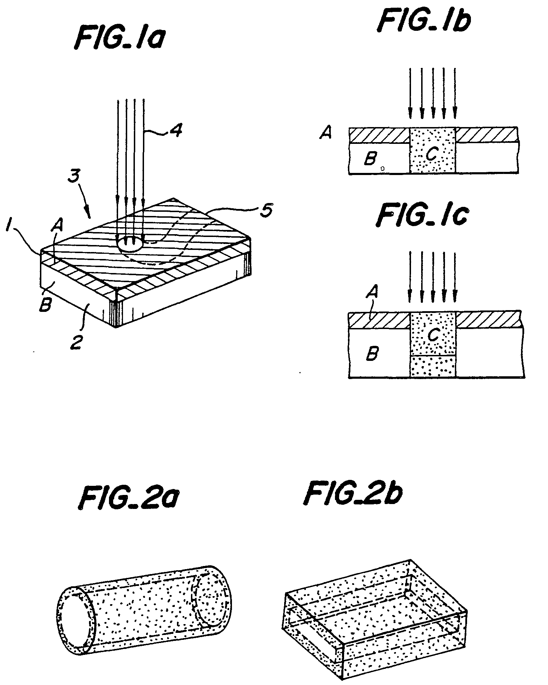

In Figures 1a, 1b and 1c of the accompanying drawings a film layer (A) of a material 1 containing at least one type of foreign atom to be injected is adhered to a crystalline solid material (B) of metal 2 of any shape, by vacuum deposition, sputtering, beam annealing, electrodeposition, or the like. The layered structure 3 so obtained has a two layer form consisting of the film layer (A) and the crystalline solid material (B), as shown in Figure 1a, and is irradiated by an electron beam 4 directed towards the film layer (A). The dotted lines show the previously irradiated path of the beam 4.

The electron beam used for irradiation must have sufficient energy to displace foreign atoms from the film layer (A). However, depending on the elements, composition and thickness of the amorphous material to be produced, electron beams having sufficient energy to displace also atoms of the crystalline solid material (B) are utilized.

Irradiation intensity is suitably selected dependent upon the electron energy, displacement threshold energy of the foreign atoms in the film layer (A), and the atoms in the material (B), and the thickness of the amorphous material to be produced. However, the temperature of the two layer structure 3 during irradiation (termed irradiation temperature hereinafter) must be kept below the critical temperature at which the mixed layer of the film layer (A) and the material (B) is transformed into the amorphous state.

Under the above-mentioned conditions, when electrons of high energy are irradiated into the film layer (A) and the material (B), the electrons collide with the film layer (A) to displace the foreign atoms. The displaced foreign atoms are then injected into the material (B). As a result, a mixed layer of (A) and (B) is produced and the crystalline state of the mixed layer changes to the amorphous state.

Materials which can be treated by the method of the invention are semiconducting materials, ceramic materials, and metallic materials. For semiconducting materials, if the crystalline solid material is Si, film layers containing at least one of Al, Fe, Cu, Ag, Mo, Au and almost all other metals as foreign atoms, and nonmetals such as N, C, B can be used. Moreover the above elements can be injected into almost all semiconducting materials such as Ge or GaAs.

In ceramic materials, using oxides (such as $Al_2O_3$ or $ZrO_2$), nitrides (such as $Si_3N_4$) and carbides (such as SiC), the other elements forming the foreign atoms are injected by electron beam irradiation into the above compounds under nonequilibrium conditions.

In metals, by combining the metal atoms which constitute intermetallic compounds, using metal atoms which can be made by conventional methods (quenching, sputtering, deposition, etc.), or by mixing forcibly alloys which do not produce solid solutions with each other, such as two solid phases or two liquid phases, the resulting materials can be amorphized.

The required conditions of irradiation for amorphization depend upon the materials used and foreign atoms to be injected. However the essential conditions are an accelerated voltage of at least 200 kV, an electron beam intensity of at least $1 \times 10^{18}$ e/cm$^2 \cdot$ sec and an irradiation temperature of not more than 100°C.

In the method of the invention foreign atoms from the film layer (A) are injected into the solid material (B) and are mixed at the interface between the film layer and the solid material by high energy electrons. This results in the following advantages:— (1) As the electron beams penetrate further than other particle beams, as shown in Figure 1b, mixed layers (amorphous layers) several hundreds of μm in thickness can be obtained. (2) The point defects which are produced by the irradiation are of Frenkel pair form, so that amorphous layers having homogeneous compositions can be produced. As shown in Figure 1c, the point defects under the amorphous layer of the crystalline solid material (B) can be recovered by heat treatment without denaturalizing (recrystallising) the amorphous materials. (3) The diameter of the electron beams can easily be changed with electron lenses. The diameter can be minimized to about 1 nmφ. As a result, extremely fine regions can be amorphized. (4) Using the interaction between high energy electrons and a crystal (for example, channelling phenomenon of electron beams or diffraction phenomenon), the amorphous layers can be distributed in the direction of the depth of the crystal, and especially thick amorphous layers can be made.

An example of conditions of irradiation by which a mixed layer of the film layer (A) and the solid material (B) is amorphized by the method of the present invention is shown in the following table.

TABLE

| Material | | Energy of electron beam | Intensity of electron beam | Irradiation temperature | Irradiation time | Thickness of amorphous material |
|---|---|---|---|---|---|---|
| Film layer (A) thickness | Crystalline solid material (B) | | | | | |
| Au (20 nm) | Si | 2.5 MeV | $1 \times 10^{20}$ e/cm$^2 \cdot$ sec | 170°K | 15 min | 50 nm |

EP 0 193 674 B1

# EP 0 193 674 B1

Example 1

A single crystal of silicon of <111> orientation was formed with an ultrasonic processing machine into a disk 3 mm in diameter having a hollow in the centre. The disk was chemically polished to form a film having a hole therthrough. A film layer of Au of about 10—20 nm (100—200 Å) thick was evaporated onto one side of the film at a vacuum of $1.33\times10^{-3}$ Pa ($10^{-5}$ Torr) or less. The double film so obtained was irradiated with electron beams of 2 to 2.5 MeV directed towards the Au side of the double film for 10 to 30 minutes at an irradiation intensity of $1\times10^{20}$ e/cm$^2 \cdot$ sec. The irradiation temperature was changed from −110°C to room temperature. Formation of the Au-Si amorphous material was recognized by production of the appropriate electron diffraction image and the dark field image.

Effects of the method of the invention are as follows:

(A) In the method of the invention, by choosing the type of film layer attached to the surface of the crystalline solid material, the kinds of foreign atoms to be injected can be freely selected, and two or more types of foreign atoms can be injected at the same time or individually. Thus materials which cannot be amorphized by conventional methods can be amorphized by injecting the correct amount of any foreign atom with electron beams.

(B) The rapid quenching process which is used in conventional methods is unnecessary. Therefore, material can be treated which is bigger and more complex in shape, and the surface layer (several μm to several hundreds μm in thickness) can be amorphized. As a result, composite materials can easily be produced by covering the surface of pipes of different diameters, wire, and plate with amorphous material as shown in Figure 2.

(C) In the conventional methods, only composites of amorphous materials and crystalline materials having the same chemical composition can be produced. However, with the present invention, as the chemical composition of amorphous layers can be widely changed, the properties of the resulting composite materials can be also widely changed. This invention is particularly useful in the field of semiconductor materials in which properties are changeable remarkably by a small change in the chemical composition.

(D) The diameter of the electron beams used can easily be reduced to about 1 nmφ with electron lenses. The electron beams can also be deflected and moved easily. Hence the amorphous regions which are produced by mixing the film layer (A) and the crystalline solid material (B) can be limited to very small regions having the smallest diameter of about 1 nmφ or can be changed into any dimension and form (a circle, a wire or a plate, for example). Also the depth or thickness of the amorphous layer produced can be controlled by changing the conditions of irradiation of electrons beams having high energy. Therefore, the composite materials which are so produced can have any desired combination of any geometry or form of amorphous material and crystalline material.

(E) In the method of the present invention, when conditions of irradiation forming point defects in the crystalline material are used, by the synergistic effect of the great penetration of the electron beams and the enhanced difufsion depending on the produced point defects, the thickness of the mixed layers of atoms in the film layer and crystalline material can easily be increased to several nm. If the crystalline material is a single crystal, penetration of the electron beams becomes greater by the channelling phenomenon of the high energy electrons. Furthermore, when the material is irradiated under conditions such that stress is applied to the material, the diffusion of the point defects can be enhanced, so that thick mixed layers can be produced. When this effect is utilzied in the method of the invention, the thickness of amorphous materials produced can be further increased.

The present method of amorphizing a crystalline solid material by irradiation with an electron beam is a particular embodiment of the method of injecting foreign atoms into a solid substrate using an electron beam disclosed and claimed in the present Applicant's copending European application 85 306 679.3 (EP—A—0 192 874). Such method comprises providing a layered structure made up of the solid substrate and at least one film layer adhered to one surface of said solid substrate, which film layer contains at least one type of foreign atom to be injected, and irradiating a predetermined region of the structure with an electron beam directed towards the film layer to cause aimed displacement of said at least one type of foreign atom from the film layer into the solid substrate, without thermal diffusion, to provide a zone of mixed atoms in the irradiated region, said zone of mixed atoms having a concentration of said at least one type of displaced foreign atom which ranges up to supersaturation and which is independent of the thermal equilibrium state, and said electron beam having an energy which is greater than the threshold energy for that at least one type of displaced foreign atom.

## Claims

1. A method of amorphizing a solid material by irradiation with an electron beam, characterised by attaching to one surface of a crystalline solid material (B) to be rendered amorphous, a film layer (A) containing at least one type of foreign atom to be injected into the crystalline solid material (B) so that the material (B) and attached layer (A) form a layered structure (3), and irradiating the structure (3) with an electron beam (4) directed towards the film layer (A), at an accelerated voltage of at least 200 kV, with an electron beam intensity of at least $1\times10^{18}$ e/cm$^2$sec and at a temperature of not more than 100°C, thereby to

5

**EP 0 193 674 B1**

displace foreign atoms from the layer (A) and inject the displaced foreign atoms into the irradiated regions of the crystalline solid material (B) and render the crystalline material amorphous.

2. A method according to Claim 1, wherein said at least one type of foreign atom contained in the film layer (A) is Au and the crystalline solid material (B) is Si.

**Patentansprüche**

1. Verfahren zum Überführen eines Feststoffes in den amorphen Zustand durch Bestrahlung mit einem Elektronenstrahl, dadurch gekennzeichnet, daß man auf einer Oberfläche eines kristallinen Feststoffes (B), der amorph gemacht werden soll, eine Filmschicht (A) befestigt, die wenigstens eine in den kristallinen Feststoff (B) einzubringende Feststofftype enthält, so daß das Material (B) und die befestigte Schicht (A) eine Schichtstruktur (3) bilden, und die Struktur (3) mit einem auf die Filmschicht (A) gerichteten Elektronenstrahl (4) mit einer Beschleunigungsspannung von wenigstens 200 kV, mit einer Elektronen-strahlintensität von wenigstens $1 \times 10^{18}$ e/cm$^2$sec und bei einer Temperatur von nicht mehr als 100°C bestrahlt, um dabei Fremdatome aus der Schicht (A) zu verlagern und die verlagerten Fremdatome in die bestrahlten Bereiche des kristallinen Feststoffes (B) einzubringen und das kristalline Material amorph zu machen.

2. Verfahren nach Anspruch 1, bei dem die in der Filmschicht (A) enthaltene wenigstens eine Fremdatomtype Au ist und der kristalline Feststoff (B) Si ist.

**Revendications**

1. Procédé pour rendre amorphe un matériau solide par irradiation avec un faisceau électronique, caractérisé par la fixation à une surface d'un matériau solide cristallin (B) devant être rendu amorphe d'une couche mince (A) contenant au moins un type d'impureté devant être injectée dans le matériau solide cristallin (B) de façon que le matériau (B) et la couche fixée (A) forment une structure en couches (3) et par l'irradiation de la structure (3) avec un faisceau électronique (4) dirigé vers la couche mince (A) à une tension accélérée d'au moins 200 kV avec une intensité du faisceau électronique d'au moins $1 \times 10^{18}$e/cm$^2$sec et une température ne dépassant pas 100°C, permettant de déplacer des impuretés en provenance de la couche (A) et d'injecter les impuretés déplacées dans les régions irradiées du matériau solide cristallin (B) et de rendre le matériau cristallin amorphe.

2. Procédé selon la revendication 1, dans lequel ledit au moins un type d'impureté contenue dans la couche mince (A) est Au et dans lequel le matériau solide cristallin (B) est Si.

6

# FIG.1a

# FIG.1b

# FIG.1c

# FIG.2a

# FIG.2b